# EUROPEAN PATENT APPLICATION

(11) **EP 3 165 490 A1**
(43) Date of publication of application: **10.05.2017**
(21) Application number: 15193576.4
(22) Date of filing: 09.11.2015
(51) Int. Cl.: B65H 59/40, B65H 63/032, D01H 13/20, D05B 47/06, G01L 5/10

(54) **A DEVICE FOR THE TRANSFER OF A MECHANICAL FORCE INTO AN ELECTRICAL SIGNAL**

(71) Applicant: Eltex of Sweden AB, 283 50 Osby (SE)
(72) Inventor: Hansson, Jonas, 283 45 Osby (SE); Hicks, Brian, Greenville, SC29601 (US); Karlsson, Bengt, 343 37 Älmhult (SE)
(74) Representative: Nilsson, Lennart

(57) **Abstract**

The present invention concerns a device for the transfer of a mechanical force to a piezo-electric element for the generation of an electrical signal corresponding to the mechanical force, e.g. the tension of a thread or the like and/or the movement of the same, wherein the piezo-electric element is positioned in a holder in order to be actuated by the mechanical force on the end surfaces.

## Description

The present invention concerns a device for the transfer of a mechanical force to a piezo-electric element for the generation of an electrical signal corresponding to the mechanical force, e.g. the tension of a thread or the like and/or the movement of the same.

There are increasing requirements imposed on devices for the transfer of mechanical forces into electrical signals. This applies particularly in the use of the devices as so-called thread sensors in, for instance, sewing machines, since there are increasing requirements of the final product, which in many cases has to possess extraordinarily exact and accurate properties. A principal object within this technical field is to improve and refine arrangements of this type with the purpose of achieving a simpler arrangement but simultaneously more sensitive, faster, and above all more accurate.

The task of providing for the object set forth forms the basis of the present invention.

According to the present invention, this task is solved in the device mentioned by way of introduction by the piezo-electric element being positioned in a holder in order to be actuated by the mechanical force on the end surfaces. The piezo-electric element is a primarily rectangular plate, one end surface of which hits on a wall in the holder and the opposite end surface of which hits on a wall of a part in the holder receiving the mechanical force.

The holder is provided with eyes for guiding the thread in a desired path through the holder. The force-receiving part is situated in the path for the force-exerting thread, so that the tension force from the same is exerted on the force-receiving part for the transfer to the piezo-electric element. The force-receiving part has an arched surface, against which the thread abuts in its path through the holder. The arched surface is situated on a cylinder, which is manufactured from a wear resistant material, e.g. stainless steel. The piezo-electric element is positioned on a surface in the holder and that the force-receiving part primarily encloses the piezo-electric element in the holder between the wall of the holder and the wall of the force-receiving part. The force-receiving part is displaceable in the holder for at least the mounting of the piezo-electric element in the same against the force of a spring.

By the present invention, transfer of the force from the thread to the piezo-electric element is facilitated for obtaining as optimum a signal as possible and this in addition without any greater risk of the piezo-electric element becoming subjected to unnecessary stresses, which could give rise to devastating cracks. Such stresses, which may arise when the piezo-electric element is subjected to bending. By exerting, according to the device according to the present invention, the mechanical force between the end surfaces of the piezo-electric plate in the longitudinal direction of the same, the obtained signal is optimized. In the device according to the present invention, the piezo-electric element is protected against external force. A further advantage of the device according to the present invention is that the mechanical force is transferred without any parts being subjected to any appreciable movement of only in the order of micrometer, which may be considered to be almost non-existent. Yet an advantage of the device according to the present invention is that it can be manufactured in an extraordinarily easy way by additive manufacture in, for instance, a 3D printer.

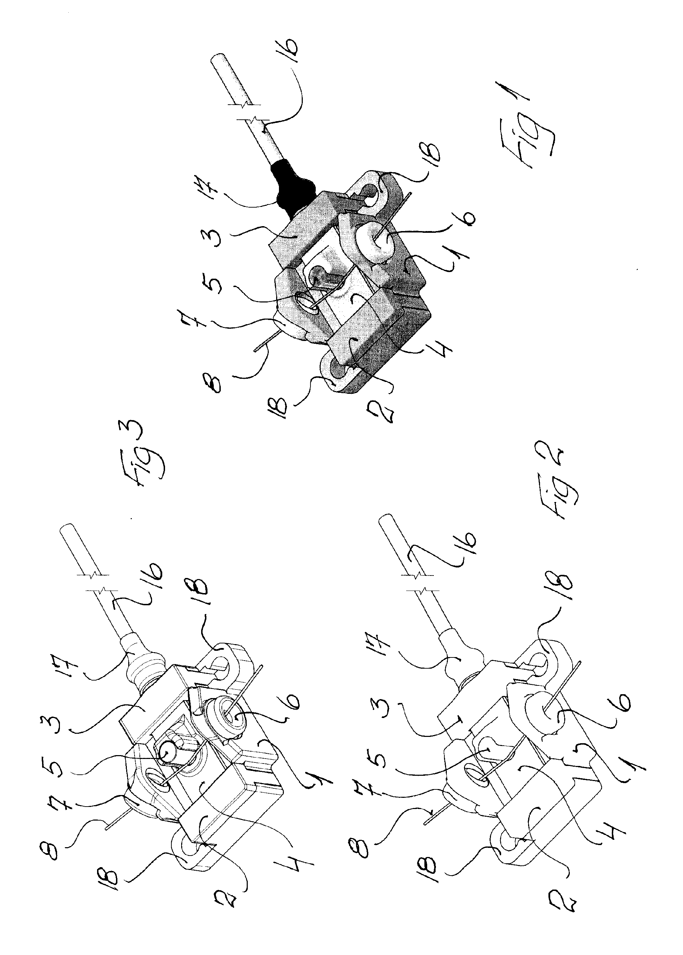

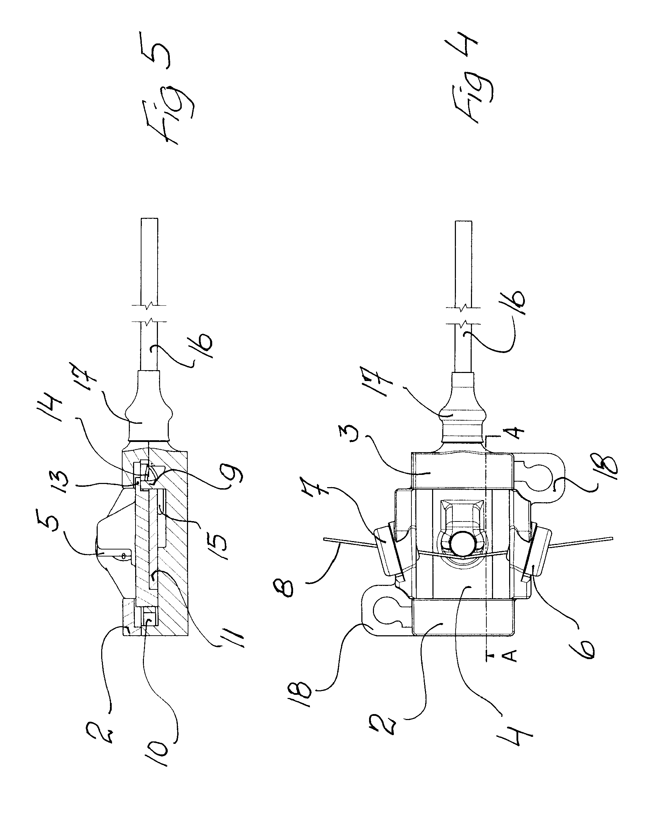

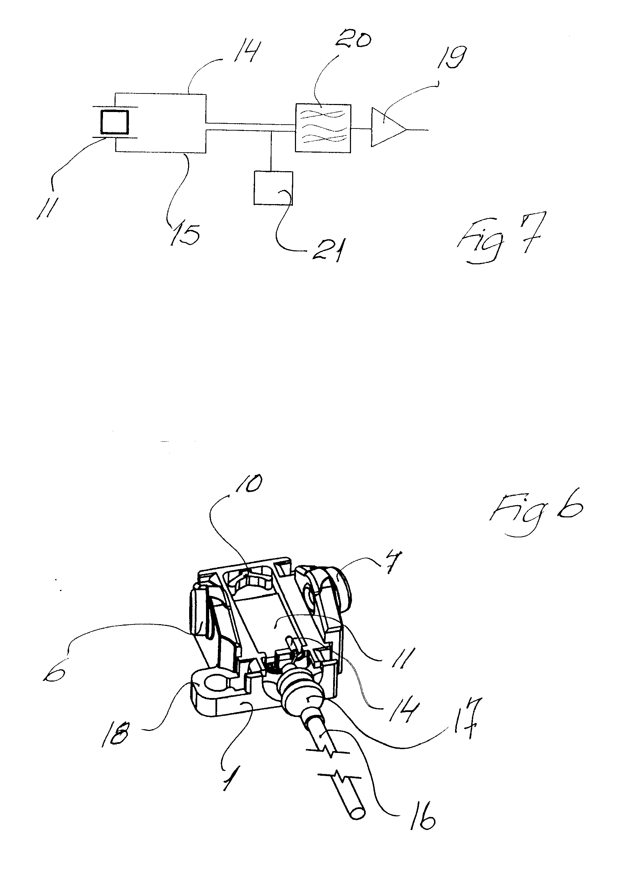

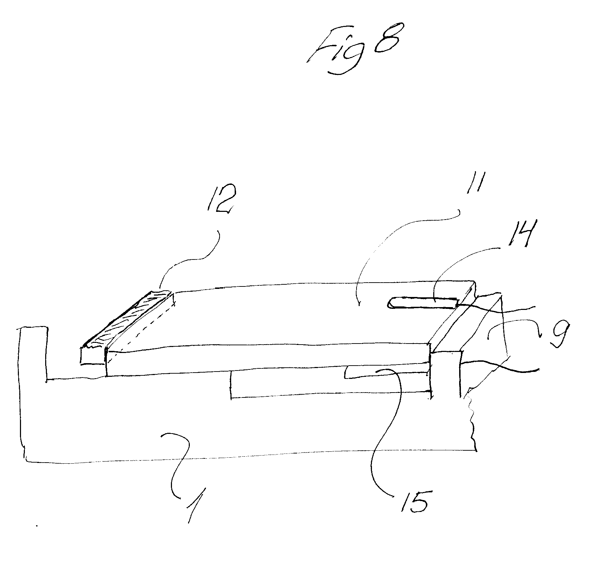

An embodiment example of a device according to the present invention will in the following be described in more detail, reference being made to the appended drawings. Fig. 1 shows a photographic view obliquely from the front of a device according to the present invention. Fig. 2 shows a similar view as Fig. 1 but only with contour lines of the device according to the present invention. Fig. 3 shows a similar view as Figs. 1 and 2 with construction lines of the device according to the present invention. Fig. 4 shows a view from above of the device according to the present invention. Fig. 5 shows a section along the line A-A in Fig. 3 of the device according to the present invention. Fig. 6 shows a view in the opposite direction in relation to Fig. 3, wherein a number of parts have been removed. Fig. 7 shows a wiring diagram of a device according to the present invention. Fig. 8 shows a simplified view of a part of another embodiment of a device according to the present invention.

The embodiment shown in the drawings of a device according to the present invention is intended to be used as a yarn sensor in a sewing machine for the manufacture of, for instance, airbags, which require an extraordinarily accurate monitoring of in principle each stitch. The device has a holder with a bottom part 1 and a first upper part 2 and a second upper part 3, which upper parts 2 and 3 are in the form of clamps and extend over a respective end of a force-receiving part 4. The bottom part 1 is provided with an eye 6 and an eye 7, which form a path for a thread 8 extending through the device and which should be monitored. The eyes 6,7 are fixed in a respecttive vertical wall of the bottom part 1 and are manufactured from a suitable material, which is suited for the cooperation with the thread and which may be an aluminium oxide. This force-receiving part 4 is provided with a cylinder 5, which is recessed in the force-receiving part 4 in such a position that the thread 8 deviates from a principally straight path through the device and exerts a force on the cylinder 5 corresponding to the tension occurring in the thread 8. The cylinder 5 is manufactured from a wear resistant material, e.g. stainless steel or a suitable aluminium oxide.

A distance inside one end of the bottom part 1, it is provided with a vertical wall 9, and at the opposite end, the bottom part 1 is provided with at least one spring 10. The force-receiving part 4 has on its underside a recess for a piezo-electric element 11, which is in the form of a rectangular plate and which rests on a surface in the bottom part 1 and extends toward the wall 9, so that the end surface of the plate rests against the same. In the recess underneath the force-receiving part 4, a wall 12 is formed. The piezo-electric plate 11 extends between the walls 9 and 12 so that the end surfaces of the piezo-electric plate hit on the walls 9 and 10, whereby a force that is exerted on the force-receiving part 4 of the thread 8 will be exerted on the end surfaces of the piezo-electric plate 11 by the same abutting against or hitting on the walls 9 and 12. At the end being opposite in relation to the wall 12, the force-receiving part 4 has a lip 13, which rests on the wall 9. There is a small play between the wall of the force-receiving part 4 being perpendicular in relation to the lip 13 and the wall 9.

The piezo-electric element 11 has an upper contact layer for an upper connecting wire 14 and a lower contact layer for a lower connecting wire 15, which are included in a connection cable 16, which extends to electronic circuits, known *per se* for this purpose, for the evaluation of the signal obtained from the piezo-electric element 11. The connecting wires 14 and 15 extend through suitable openings or recesses in the wall 9. Such electronic circuits are exemplified in Fig. 7 and the appurtenant description section.

The first upper part or the clamp 2 extends over the end of the force-receiving part 4 to retain it in the bottom part 1 and the piezo-electric element 11 in the recess of the underside thereof. The second upper part 3 extends over the lip 13 of the force-receiving part 4 for the retention of the same against the wall 9 and the end of the cable 16 for the connecting wires 14 and 15 of the device. A strain relief sleeve 17, which may be a shrink tube, facilitates the retention of the parts to each other. The bottom part 1 is provided with a fixing lug 18 at the diagonally opposite corners.

The parts included in the device in addition to the piezo-electric element 11, the connecting wires 14 and 15, and the cylinder 5 are advantageously manufactured from a suitable plastic material or materials, which are usable in a 3D printer, which implies additive manufacture.

The force that is exerted by the thread 8 on the cylinder 5 and thereby the force-receiving part 4 will be transferred to the piezo-electric element 11 in the longitudinal direction thereof without there arising any material movement between the parts, perhaps possibly in the order of a micrometer or part thereof. This means that the movement of the thread 8 through the device will be primarily constant and unaffected by the device.

Fig. 6 shows parts of the device according to the present invention for clarifying the positioning of the piezo-electric element 11 and the upper connection 14 thereof. Further, the spring 10 for the retention of the force-receiving part 4 is shown. The spring 10 has two arms, which start out from a waist, which in turn starts out from the bottom part 1.

Fig. 7 shows a simple wiring diagram of the device according to the present invention. The piezo-electric element 11 is, via the connecting wires 14 and 15, coupled to a signal amplifier 19 via a filter 20, which may be a bandpass filter or of some other type depending on how the signal should be evaluated. Further, the circuit is coupled to a reference voltage source 21. The signal from the amplifier 19 may be used in various ways, e.g. for triggering an alarm or the like, which warns a machine operator of the fact that the tension of the thread 8 deviates from a desired value for the adoption of suitable measures.

In Fig. 8, a simplified view is shown over parts of another embodiment of the device according to the present invention. The principal difference in relation to the embodiment described above is that the mechanical force from the thread 8 via the force-receiving part 4 is exerted via the wall 12 thereof only on a part of the end surface of the piezo-electric element 11, and that only a part of the opposite end surface of the piezo-electric element 11 rests against the wall 9, whereby the force on the upper side becomes counterdirected to the force on the underside, so that the piezo-electric element 11 is subjected to a shearing effect in the longitudinal direction of the same.

It is feasible to have the piezo-electric element 11 in the form of a lying cylinder in both embodiments described above and if so, the adjacent parts are naturally shape-adapted to the cylindrical piezo element.

Advantageously, the eyes 6 and 7 may be attached to the bottom part 1 by means of a suitable glue. The pillar 5 may also be attached to the force-receiving part 4 by means of a suitable glue. The upper parts 2 and 3 have a snap-in function and hold together the strapped parts and in the correct position.

Numerous modifications of the embodiment example described above of a device according to the present invention may be made within the scope of the general idea of the invention defined in the subsequent claims.

## Claims

1. Device for the transfer of a mechanical force to a piezo-electric element for the generation of an electrical signal corresponding to the mechanical force, e.g. the tension of a thread or the like and/or the movement of the same, **characterized in that** the piezo-electric element is positioned in a holder in order to be actuated by the mechanical force on the end surfaces.

2. Device according to claim 1, **characterized in that** the piezo-electric element is a primarily rectangular plate, one end surface of which hits on a wall in the holder and the opposite end surface of which hits on a wall of a part of the holder receiving the mechanical force.

3. Device according to claim 2, **characterized in that** the holder is provided with eyes for guiding the thread in a desired path through the holder.

4. Device according to claim 3, **characterized in that** the force-receiving part is situated in the path for the force-exerting thread, so that the tension force from the same is exerted on the force-receiving part for the transfer to the piezo-electric element.

5. Device according to claim 2 or 4, **characterized in that** the force-receiving part has an arched surface, against which the thread abuts in its path through the holder.

6. Device according to claim 5, **characterized in that** the arched surface is situated on a cylinder, which is manufactured from a wear resistant material, e.g. stainless steel.

7. Device according to any one of the preceding claims, **characterized in that** the piezo-electric element is positioned on a surface in the holder, and that the force-receiving part primarily encloses the piezo-electric element in the holder between the wall of the holder and the wall of the force-receiving part.

8. Device according to claim 7, **characterized in that** the force-receiving part is displaceable in the holder for at least the mounting of the piezo-electric element in the same against the force of a spring.
